# EUROPÄISCHE PATENTANMELDUNG

(11) **EP 4 498 604 A1**
(43) Veröffentlichungstag der Anmeldung: **29.01.2025**
(21) Anmeldenummer: 24190771.6
(22) Anmeldetag: 25.07.2024
(51) Int. Cl.: H03K 17/95

(54) **SPULENSYSTEM FÜR EINEN INDUKTIVEN NÄHERUNGSSCHALTER ZUM BÜNDIGEN ODER NICHTBÜNDIGEN EINBAU IN EIN GEHÄUSE**

(30) Priorität: 28.07.2023 DE 102023120087
(71) Anmelder: Turck Holding GmbH, 58553 Halver (DE)
(72) Erfinder: Faber, Michael, 58762 Altena (DE)
(74) Vertreter: DTS Patent- und Rechtsanwälte PartmbB

(57) **Zusammenfassung**

Die vorliegende Offenbarung betrifft ein Spulensystem für einen induktiven Näherungsschalter zum bündigen oder nichtbündigen Einbau in ein Gehäuse. Das Spulensystem weist eine Spulenplatine auf, auf der zumindest eine erste Empfangsspule und eine Sendespule angeordnet sind. Dabei umfasst die Sendespule eine Spule, die in ihrer Form polygonal ausgebildet ist.

## Beschreibung

Die vorliegende Offenbarung betrifft ein Spulensystem für einen induktiven Näherungsschalter zum bündigen oder nichtbündigen Einbau in ein Gehäuse. Ferner betrifft die Offenbarung einen induktiven Näherungsschalter mit dem Spulensystem sowie ein Verfahren zum Herstellen des Spulensystems.

Induktive Sensoren mit gewickelten Spulen, die zur Ausrichtung des elektromagnetischen Feldes in einen Ferritkern eingesetzt werden sind im Stand der Technik bekannt.

Besondere Herausforderungen bringt der Bau von Sensoren mit sich, die bündig in ein Gehäuse eingesetzt werden sollen und dann in Umfangsrichtung von dem Gehäuse umgeben sind. Insbesondere metallische Gehäuse haben eine abschirmende Wirkung, was vor allem die Funktion der Empfängerspulen beeinträchtigt. Es werden daher üblicherweise besondere Sensorvarianten für den bündigen Einbau konstruiert, bei denen die Empfängerspulen einen bestimmten Abstand vom umgebenden Gehäuse aufweisen. Allerdings führt dies dazu, dass die Empfangsspulen bei Sensoren für den bündigen Einbau einen geringeren Durchmesser aufweisen als bei den Varianten für nichtbündigen Einbau und schlechtere Detektionseigenschaften haben.

Die Durchmesser der Ferritkerne für bündige und nichtbündige Sensoren können aufgrund des räumlichen Abstandes, den die Spule bei den bündigen Geräten zur internen Abschirmung haben muss, sehr unterschiedlich sein. Für gewickelte 3-Kammer-Spulen der Faktor-1-Sensoren kann dieser Zusammenhang ebenso gelten.

Bei Faktor-1-Sensoren mit gedruckten Spulen können die Durchmesser der gedruckten Spulen für die bündigen Sensorvarianten ebenfalls kleiner als die Spulendurchmesser der nichtbündigen Sensorvarianten sein oder sie müssen durch Kompensationswindungen für den Einbau in Metall beschnitten werden, was zur Folge haben kann, dass große Schaltabstände, wie sie für nichtbündige Varianten marktüblich sind, nicht erreicht werden können. Damit gibt es bei diesen Sensoren ebenfalls unterschiedliche Spulenplatinen für nichtbündige und bündige Sensoren.

Im Stand der Technik werden verschiedene Ausgestaltungen von induktiven Sensoren vorgeschlagen. Induktive Näherungssensoren mit einer Sende- und Empfangsspule detektiert eine Dämpfung des Schwingkreises bei Annäherung eines metallischen Objekts (mit den entsprechenden magnetischen Eigenschaften) und bei einem Erreichen eines Schaltabstands wird geschaltet.

In der EP 3 688 871 A1 wird ein induktiver Näherungsschalter vorgeschlagen, der eine Sendespule, eine Empfängerspule, eine integrierte Schaltung zur Erregung der Sendespule und eine Signalverarbeitungseinheit zur Verarbeitung eines von der Empfängerspule empfangenen Signals umfasst, wobei ein Oszillator einen Schwingkreis anregt, der die Sendespule und einen Parallelkondensator zum Induzieren einer Spannung in der Empfängerspule umfasst, wobei die Empfängerspule zwei symmetrische Segmente mit entgegengesetzter Ausrichtung umfasst, die in Reihe geschaltet sind, wobei die Sendespule die Segmente der Empfängerspule umgibt oder die Sendespule von den Segmenten der Empfängerspule umgeben ist.

Den bekannten Lösungen ist gemeinsam, dass sie oft eine Geometrie aufweisen, die keinen Einsatz für sowohl nichtbündige, als auch als bündige Sensoren mit den erforderlichen Norm-Schaltabständen ermöglichen. Es müssen daher stets verschiedene Varianten einer Sensorplatine für verschiedene Einbausituationen bereitgestellt werden.

Vor dem Hintergrund dieses Standes der Technik besteht die Aufgabe der vorliegenden Offenbarung darin, ein Spulensystem für einen induktiven Näherungsschalter, einen induktiven Näherungsschalter und ein Verfahren zur Herstellung des Spulensystems anzugeben, die jeweils geeignet sind, die zuvor genannten Nachteile des Stands der Technik zumindest teilweise zu überwinden und den Stand der Technik zu bereichern.

Gelöst wird die Aufgabe durch die Merkmale der unabhängigen Patentansprüche. Die Unteransprüche haben jeweils optionale Weiterbildungen der Offenbarung zum Inhalt.

Danach wird die Aufgabe gelöst durch ein Spulensystem für einen induktiven Näherungsschalter zum bündigen oder nichtbündigen Einbau in ein Gehäuse. Das Gehäuse kann insbesondere als ein metallisches Gehäuse ausgebildet sein oder es kann zumindest Metall umfassen. Das Spulensystem weist eine Spulenplatine auf, auf der zumindest eine erste Empfangsspule und eine Sendespule angeordnet sind. Dabei umfasst die erste Empfangsspule eine Spule, die in ihrer Form polygonal ausgebildet ist.

Die Empfangsspule und die Sendespule können insbesondere als eine gedruckte Spule ausgebildet sein. Sie können ferner in Lagen übereinander angeordnet sein.

Im Sinne der vorliegenden Offenbarung kann unter einem bündig beziehungsweise vollbündig einbaubaren Sensor ein Sensor verstanden werden, der vollständig bis zur obersten Sensorfläche in das umgebene Material des Gehäuses, insbesondere ein Metall, eingelassen wird.

Beim nichtbündigen Einbau eines Sensors ist dagegen ein Freiraum um die aktive Fläche herum vorgesehen. In der Regel ist vorgesehen, dass ein nichtbündig eingebauter Sensor ein Stück weiter aus dem Gehäuse heraussteht, insbesondere so, dass die Spulen nicht von metallischem Material umgeben sind.

Das Gehäuse stellt hierbei ein Element mit einer Oberfläche dar, in dem der Sensor verbaut sein kann und der nichtbündige Sensor aus der Oberfläche übersteht. Somit ist der nichtbündige Sensor nicht vollständig in dem Metall versenkt, sodass dieses nicht abschirmend wirkt.

Das vorliegend beschriebene Spulensystem für einen induktiven Näherungsschalter bietet dabei eine Reihe von Vorteilen. Unter anderem kann ein Spulensystem aus einer Sende- und einer Empfangsspule (alternativ mit weiteren Empfangsspulen) auf einer Frontspulenplatine ausgebildet werden, wobei große Schaltabstände beim nichtbündigen Einbau erhalten werden und selbst bei einem bündigen Einbau dieser Sensoren ein großer Schaltabstand ermöglicht wird.

Zudem wird ein einfacher Aufbau erzielt und damit eine kostengünstige und automatisierte Herstellung der Sensoren ermöglicht.

Zudem ergibt sich durch den Aufbau eine hohe Temperatur- und Langzeitstabilität der Sensoren.

Zudem kann der Einfluss externer Magnetfelder auf das Schaltverhalten minimiert werden.

Ferner kann eine einzige Spulenvariante beziehungsweise Spulenplatine pro Sensorbauform für Gerätevarianten sowohl mit bündigem als auch mit nichtbündigem Einbau bereitgestellt werden. Damit können also identische Sensorbeziehungsweise Elektronikbaugruppen für die Gehäusevarianten verwendet werden.

Ferner können Baugruppen, Module und Plattformen zusammengefasst werden, womit sich Vorteile in der Logistik und bei den eingekauften Materialkosten beziehungsweise den Herstellkosten der Sensoren ergeben.

Nachfolgend werden mögliche Weiterbildungen des oben beschriebenen Verfahrens im Detail erläutert.

Es kann vorgesehen sein, dass die polygonale Form der ersten Empfangsspule so ausgebildet ist, dass ihre Eckpunkte zumindest teilweise in einem Randbereich der Spulenplatine angeordnet sind. Die Breite des Randbereichs kann beispielsweise bis zu zwei Zehntel, bevorzugt bis zu einem Zehntel einer Breite der Spulenplatine betragen. Auf diese Weise wird vorteilhafterweise an den Ecken des Polygons ein möglichst großer Spulendurchmesser der Empfangsspule erhalten, sodass ein großer Schaltabstand erzielt werden kann.

Die Seitenlängen des Polygons sind dann weiter von dem Rand der Spulenplatine und daher auch von einem umgebenden Gehäuse entfernt als die Ecken. In diesen Bereichen der Spule ist daher eine Abschirmung beziehungsweise Beeinflussung eines Messignals durch ein umgebendes Gehäuse minimiert.

Es kann vorgesehen sein, dass die erste Empfangsspule eine konvex polygonale Form aufweist, insbesondere eine regelmäßig konvex polygonale Form. "Konvex" meint in diesem Zusammenhang, dass alle Innenwinkel kleiner als 180° sind. "Regelmäßig" heißt hier, dass das Polygon gleichwinklig ist. Alternativ kann zumindest ein Winkel größer als 180° sein, das heißt das Polygon kann zumindest teilweise konkav sein, beispielsweise bei einer Stern-Form.

Optional kann die polygonale Form vier Seitenlängen und vier Innenwinkel aufweisen, die insbesondere symmetrisch und gleichmäßig zueinander verteilt sind. Optional weist die erste Empfangsspule eine Rautenform auf, insbesondere eine quadratische Form.

Die Geometrie der Empfangsspule kann beispielsweise in Form einer Raute oder eines Quadrats umgesetzt werden, so dass nur an den vier Eckpunkten der Spulendurchmesser maximal ist, aber an den Seitenflächen ein größerer Abstand zum umliegenden Metall des Gehäuses erreicht werden kann, sei es eine interne metallische Abschirmung oder eine metallische Montagefläche für den Sensor. Somit erfolgt keine wesentliche Beeinflussung der auszuwertenden Differenzspannung.

Somit kann eine einzige Spulenplatine genutzt werden, um die Auswertung und den zu erfassenden Schaltabstand mit dieser speziellen Spulengeometrie für bündige und nichtbündige Sensorvarianten zu ermöglichen.

Es kann vorgesehen sein, dass die Sendespule eine kreisrunde Form aufweist, wobei optional die Sendespule einen auf der Spulenplatine maximal auszubildenden Durchmesser aufweist. Das heißt, der Durchmesser der Sendespule ist möglichst groß ausgebildet, insbesondere bis an den Rand oder bis in den Randbereich der Spulenplatine. Somit kann die Ausbreitung des elektromagnetischen Felds der Sendespule mit größtmöglicher Reichweite erzielt werden.

Es kann vorgesehen sein, dass ferner zumindest eine zweite Empfangsspule vorgesehen ist. Die erste Empfangsspule und die zweite Empfangsspule können auf der Spulenplatine lagenweise übereinander angeordnet sein, wobei die erste und die zweite Empfangsspule in der lagenweisen Anordnung jeweils mit bis zu 3 Lagen ausgebildet sind. Dabei ist die Sendespule zwischen der ersten und der zweiten Empfangsspule angeordnet, und die Sendespule ist mit einer Mehrzahl von Lagen, insbesondere in einem Bereich von 1 bis 5 Lagen, ausgebildet. Weiterhin können Lagen in einem Bereich von 3 bis 5 vorgesehen sein.

Die erste und die zweite Empfangsspule können jeweils eine gedruckte Spule umfassen oder als gedruckte Spulen ausgebildet sein.

Es kann vorgesehen sein, dass die erste Empfangsspule und die zweite Empfangsspule entgegengesetzte Wicklungsrichtungen aufweisen.

Bei einem Beispiel kann vorgesehen sein, dass für die erste Empfangsspule bis zu 3 Lagen mit gleicher Wickelrichtung, das heißt gleicher Richtung hinsichtlich des Stromdurchflusses, verwendet werden. Folgend werden bis zu 5 Lagen für die Sendespule, alle mit gleicher Wickelrichtung, vorgesehen. Anschließend sind bis zu 3 Lagen für die zweite Empfangsspule, mit einer entgegengesetzten Wickelrichtung zu der ersten Empfangsspule, vorgesehen. Zusätzlich sind eine Lage für ein Abschirmgitter gegen HF-Störungen, eine Lage für die entsprechenden Verbindungsleiterbahnen und eine weitere Lage für entsprechende Anschluss-Pads zu einer Elektronikplatine vorgesehen.

Es kann ferner vorgesehen sein, dass der Stapel der Spulenplatine insgesamt 8 bis 16 Lagen, insbesondere 8 bis 14 Lagen, vorzugsweise 14 Lagen, aufweist. Die Anzahl der Lagen, beispielweise 14 Kupferlagen, kann derart gestaltet werden, um die Spulenplatine weniger komplex und aufwendig zu gestalten, aber trotzdem Platz für das Layouten der Kupferlagen für die Empfangs- und Sendespulen zur Verfügung zu haben. Zudem sind die Komplexität und der Aufwand der Fertigung sowie die Kosten stark abhängig von der Anzahl der Lagen und damit teurer im Einkauf, wenn die Anzahl der Lagen höher ist. Daher ist es vorteilhaft, wenn die Spulenplatinen weniger komplex ausgebildet sind und zudem für nichtbündige und bündige Einbausituationen verwendet werden können.

Der induktive Näherungsschalter umfasst ein Spulensystem gemäß der vorliegenden Beschreibung und ein Gehäuse. Dabei ist das Spulensystem bündig oder nichtbündig in oder an dem Gehäuse angeordnet.

Das Gehäuse weise eine Gehäusequerschnittsfläche auf. Insbesondere ist die Gehäusequerschnittsfläche entlang einer Ebene definiert, die durch die Spulenplatine im eingebauten Zustand aufgespannt wird.

Das Gehäuse kann dabei zumindest teilweise aus Metall gebildet sein. Das Spulensystem kann ferner im eingebauten Zustand in Umfangsrichtung zumindest teilweise von Metall umgeben sein.

Die Gehäusequerschnittsfläche kann beispielsweise rund ausgebildet sein. Ferner beispielsweise kann die Empfangsspule quadratisch geformt sein, wobei die Ecken des Quadrats im Wesentlichen bis an den Rand, das heißt bis dicht an das Gehäuse heran, reichen.

Die Gehäusequerschnittsfläche kann bei einem anderen Beispiel quadratisch ausgebildet sein. Eine quadratische Gehäusequerschnittsfläche kann sich besonders gut zur Aufnahme der quadratischen Form oder der länglichen Rautenform der Empfangsspule eignen.

Alternativ kann auch eine längliche ovale oder rechteckige Gehäusequerschnittsfläche vorgesehen sein, die beispielsweise zur Aufnahme einer Empfangsspule mit einer Rautenform geeignet sind.

Es kann vorgesehen sein, dass die Empfangsspulen gegenüber einer quadratischen Gehäusequerschnittsfläche des Gehäuses um 45° gedreht angeordnet sind. Die Empfangsspule kann länglich rautenförmig oder quadratisch ausgebildet sein, sodass sie einerseits einen großen Durchmesser hat (an den Ecken) und andererseits weit vom umgebenden metallischen Gehäuse entfernt ist. Besonders ausgeprägt ist dies, wenn die, insbesondere quadratisch ausgebildete, Empfangsspule um 45° gedreht orientiert ist gegenüber der quadratischen Gehäusequerschnittsfläche. Die Ecken des Quadrats der Spule sind damit dicht am quadratischen Gehäuse angeordnet, während an den Seiten des Quadrats der Spule ein größerer Abstand zu den Ecken des quadratischen Gehäusequerschnitts erhalten wird.

Das oben Beschriebene lässt sich mit anderen Worten auf eine mögliche konkretere Ausgestaltung der Offenbarung wie nachfolgend beschrieben zusammenfassen, wobei die nachfolgende Beschreibung als für die Offenbarung nicht einschränkend auszulegen ist. Die Geometrie der Spulen kann mit den Anforderungen so angepasst werden, dass mit einem Spulendesign sowohl nichtbündige, als auch als bündige Sensoren mit den erforderlichen und marktüblichen Norm-Schaltabständen realisiert werden können.

Um ein derartiges Verhalten erreichen zu können, ist eine Sendespule auf der Spulenplatine insbesondere mit maximal möglichem Durchmesser vorgesehen worden, so dass die Ausbreitung des elektromagnetischen Feldes mit einer größtmöglichen Reichweite sichergestellt werden kann.

Die Geometrie der Empfangsspulen kann in Form einer Raute umgesetzt werden, so dass nur an den vier Eckpunkten der Spulendurchmesser maximal ist, aber an den Seitenflächen ein größerer Abstand zum umliegenden Metall ausgebildet wird, sei es eine interne metallische Abschirmung oder eine metallische Montagefläche für den Sensor, dass keine wesentliche Beeinflussung der auszuwertenden Differenzspannung erfolgt.

Somit kann die Auswertung und der zu erfassenden Schaltabstand mit dieser speziellen Spulengeometrie und nur einer Spulenplatine für bündige und nichtbündige Sensorvarianten ermöglicht werden.

Dieses Spulensystem ist ohne weitere vorherige Anpassung in der jeweiligen Einbausituation abgleichbar und einsetzbar. Es können beispielsweise zwei Varianten bezüglich der Geometrie des Einbaus vorgesehen sein, nämlich ein runder oder ein eckiger Einbau.

Bei zylindrischen Sensoren ragt typischerweise eine Frontkappe aus dem Gehäuse heraus, das heißt der Sensor ist nicht-bündig in das Gehäuse eingebaut, allerdings ist ein Abgleich auf bündigen Schaltabstand dennoch möglich.

Es können zwei Empfangsspulen vorgesehen sein, nämlich eine Empfangsspule vor der Sendespule und eine Empfangsspule hinter der Sendespule - die Sendespule ist dann zwischen einer ersten und einer zweiten Empfangsspule angeordnet, wobei die Spulen übereinander in einem Spulenstapel angeordnet sind. Die Empfangsspulen können etwa 3 Lagen aufweisen und in jeder Lage zum Beispiel zwischen 1,4 bis 5 Windungen aufweisen. Die Sendespule kann bis zu 5 Lagen, insbesondere in einem Bereich von 3 bis 5 Lagen aufweisen.

Die Sendespule kann rund ausgebildet sein. In jeder Lage der Sendespule sind zum Beispiel zwischen 4,0 bis 5,0 Windungen vorgesehen. Es kann vorgesehen sein, dass die Windungen der runden Sendespule möglichst breit ausgebildet sind, um möglichst niederohmig zu sein. Daher liegen die Leiterbahnen näher beieinander.

Der gesamte Stapel der Spulen ist wegen der Ausdehnung in der Höhe, beispielsweise etwa 1,5 mm, davon 12 Lagen mit Spulen, begrenzt.

Zudem wird ein Verfahren zur Herstellung eines Spulensystems für einen induktiven Näherungsschalter bereitgestellt. Das Verfahren weist mehrere Verfahrensschritten auf. In einem ersten Verfahrensschritt S1 erfolgt ein Ausbilden zumindest einer ersten Empfangsspule auf einer Spulenplatine in lagenweiser Anordnung, und in einem weiteren Verfahrensschritt S2 erfolgt ein Ausbilden einer Sendespule in lagenweiser Anordnung auf der ersten Empfangsspule. Dabei weist die Sendespule insbesondere eine Spule mit einer kreisrunden Form auf. Die erste Empfangsspule umfasst eine Spule mit einer polygonalen Form, insbesondere mit vier Seitenlängen und Innenwinkeln, die insbesondere symmetrisch und gleichmäßig zueinander verteilt sind.

Das Verfahren ist insbesondere dazu geeignet, das vorliegend beschrieben Spulensystem herzustellen. Es weist daher die entsprechenden Vorteile auf und kann in analoger Weise wie das Spulensystem weitergebildet werden.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Offenbarung umfassen auch nicht explizit genannte Kombinationen von zuvor oder im Folgenden bezüglich der in den Weiterbildungen beschriebenen Merkmalen der Offenbarung. Insbesondere wird dabei der Fachmann auch Einzelaspekte als Verbesserung oder Ergänzungen zu der jeweiligen Grundform der vorliegenden Offenbarung hinzufügen. Insbesondere können Merkmale der Vorrichtungsansprüche durch entsprechende Funktionen umgesetzt und/oder ausgeführt werden, wonach diese das Verfahren ergänzen beziehungsweise erweitern. Ferner können Verfahrensschritte durch entsprechende Implementierungsmodule in der Vorrichtung umgesetzt werden. Somit gilt das oben mit Bezug zur Vorrichtung beschriebene analog auch für das Verfahren und entsprechend umgekehrt.

Weitere Einzelheiten und Vorteile der Erfindung sollen nun anhand der in den Zeichnungen dargestellten Ausführungsbeispiele näher erläutert werden.

Es zeigen:
- Fig. 1A bis 1D: schematische Darstellungen einzelner Lagen eines offenbarungsgemäßen Spulensystems in einem induktiven Näherungsschalter;
- Fig. 2: eine schematische Darstellung einer Lage in einem weiteren induktiven Näherungsschalter; und
- Fig. 3: ein Ablaufdiagramm eines offenbarungsgemäßen Verfahrens.

Die beiliegenden Zeichnungen sollen ein weiteres Verständnis der Weiterbildung der Offenbarung vermitteln. Sie veranschaulichen Weiterbildungen und dienen im Zusammenhang mit der Beschreibung der Erklärung von Prinzipien und Konzepten der Offenbarung. Andere Weiterbildungen und viele der genannten Vorteile ergeben sich im Hinblick auf die Zeichnungen. Die Elemente der Zeichnungen sind nicht notwendigerweise maßstabsgetreu zueinander gezeigt.

In den Figuren sind gleiche, funktionsgleiche, und gleich wirkende Elemente, Merkmale und Komponenten - sofern nichts anderes ausgeführt ist - jeweils mit denselben Bezugszeichen zu versehen.

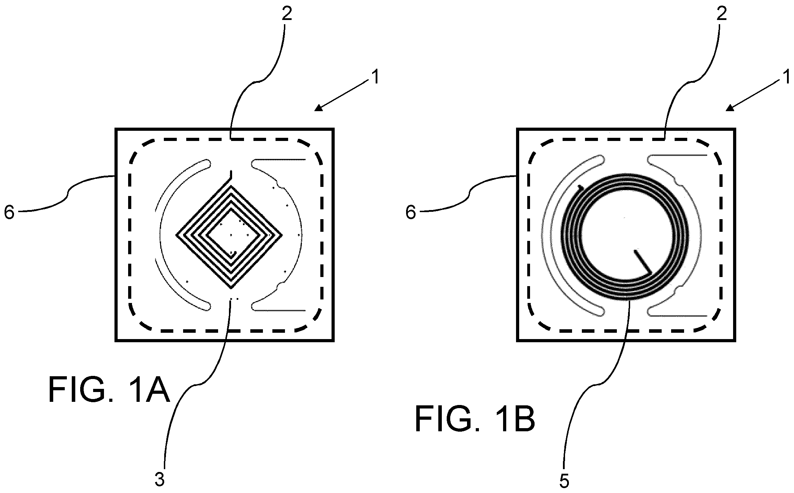

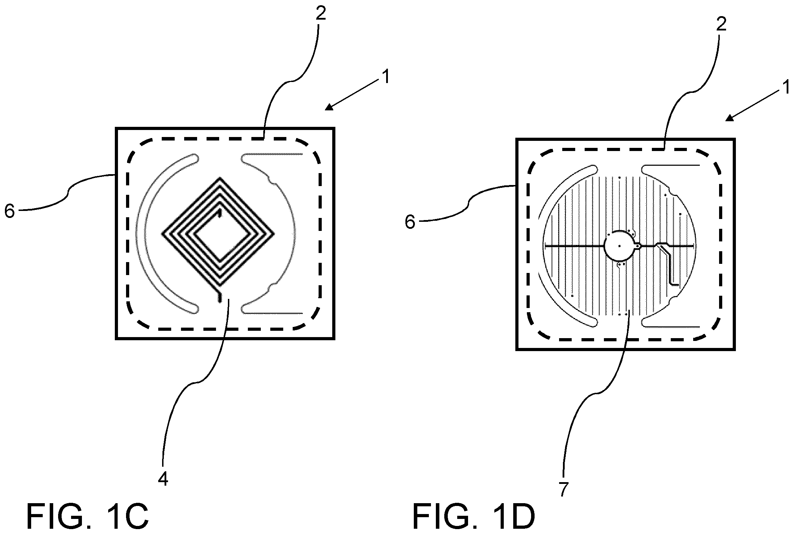

Mit Bezug zu den Fig. 1A bis 1D wird ein erstes Ausführungsbeispiel des induktiven Näherungsschalters 1 erläutert. Es sind lediglich beispielhaft und schematisch einzelne Lagen eines Spulenstapels gezeigt.

Der induktive Näherungsschalter 1 ist für den bündigen oder nichtbündigen Einbau in ein Gehäuse 6 vorgesehen. Das Gehäuse 6 kann dabei metallisch sein oder ein metallisches Material umfassen.

Beim bündigen oder nichtbündigen Einbau des induktiven Näherungsschalters (Sensor) können sich die erreichten maximalen Schaltabstände unterscheiden. Der maximale Schaltabstand eines nichtbündigen induktiven Näherungsschalters entspricht bei dem Beispiel ungefähr dem Spulen- beziehungsweise Gehäusedurchmesser. Der maximale Schaltabstand eines bündigen induktiven Näherungsschalters entspricht ungefähr dem halben Spulen-/ Gehäusedurchmesser.

Die Besonderheit des Spulendesigns des Näherungsschalters 1 liegt zum einen in der Abgleichbarkeit auf den höheren Schaltabstand für die nichtbündig eingebauten induktiven Näherungsschalter mit der Eigenschaft, dass die Sensorbaugruppe in beziehungsweise auf einer Metallumgebung eingesetzt werden kann, wo sonst nur bündige Näherungsschalter eingesetzt werden können und der Näherungsschalter weiterhin mit seinen zugesicherten Eigenschaften funktioniert.

Wenn der Näherungsschalters 1 in ein metallisches Sensorgehäuse eingesetzt wird, zum Beispiel für bündige zylindrische Sensorvarianten, dann ist diese Sensorbaugruppe ohne Zusatzarbeit oder Maßnahmen auf den erforderliche Schaltabstand abgleichbar.

Der induktive Näherungsschalter 1, der hier schematisch in einer Draufsicht auf einen Querschnitt des Gehäuses 6 gezeigt ist, weist eine Spulenplatine 2 auf.

Die Spulenplatine 2 ist zur Aufnahme mindestens einer ersten Empfangsspule 3 ausgebildet.

Die erste Empfangsspule 3 hat bei dem Beispiel eine quadratische Form, wobei sie gegenüber dem ebenfalls quadratischen Gehäusequerschnitt um 45° gedreht angeordnet ist. Sie weist einen maximalen Spulendurchmesser an den vier Eckpunkten auf, das heißt, die Eckpunkte erstrecken sich bis zum Rand eines bedruckbaren Bereichs der Spulenplatine 2. Sie bildet ferner an den vier Seitenlängen des Quadrats einen größeren Abstand zum umgebenden Gehäuse 6 aus, so dass eine Beeinflussung des erfassten Messsignals durch das umgebende Gehäuse 6 (beim bündigen Einbau) minimiert ist.

Die Empfangsspule 3 kann auf die Spulenplatine 2 gedruckt werden.

Die erste Empfangsspule 3 kann eine quadratische Form oder die Form einer Raute aufweisen oder insbesondere eine konvex polygonale Form aufweisen. Die erste Empfangsspule 3 umfasst eine Spule, die in Ihrer Form polygonal ausgebildet ist, insbesondere mit vier Seitenlängen und Innenwinkeln, die insbesondere symmetrisch und gleichmäßig zueinander verteilt sind.

Eine polygonale Form kann dabei auch eher allgemein so verstanden werden, dass die Form Ecken aufweist, bei denen die Spule bis nahe an das umgebende Gehäuse 6 angeordnet ist, sowie Kanten, bei denen ein größerer Abstand zum Gehäuse 6 erhalten wird, sodass dort ein geringerer Einfluss des Gehäuses 6 auf das Messsignal wirkt.

Bei dem Beispiel ist ferner eine zweite Empfangsspule 4 vorgesehen, die im Wesentlichen analog zu der ersten Empfangsspule 3 gebildet ist.

Ferner weist das Spulensystem des induktiven Näherungsschalters 1 eine Sendespule 5 auf, die bei dem Beispiel zwischen der ersten 3 und zweiten Empfangsspule 4 angeordnet ist.

Die Sendespule 5 umfasst eine Spule mit insbesondere einer kreisrunden Form.

Zudem weist die Sendespule 5 einen auf der Spulenplatine 2 maximal auszubildenden Durchmesser auf, das heißt, sie hat einen möglichst großen Durchmesser innerhalb des bedruckbaren Bereichs der Spulenplatine 2.

Bei dem Beispiel ist ferner vorgesehene, dass eine Spulenlage mit einem Gitter 7 versehen ist, dass den Spulenstapel in eine Richtung gegenüber elektromagnetischen Störungen abschirmt beziehungsweise welches das mit der Sendespule erzeugte Feld in eine Richtung hin abschirmt.

Die in den Fig. 1A bis 1D gezeigten Spulenformen und Ausführungen stellen keine einschränkende Ausgestaltung des Spulensystems des induktiven Näherungsschalters 1 dar.

Insbesondere ist vorgesehen, dass das Gitter 7, die erste Empfangsspule 3, die Sendspule 5 und die zweite Empfangsspule 4 gestapelt auf der Spulenplatine 2 angeordnet sind.

Die erste Empfangsspule 3 und die zweite Empfangsspule 4 sind bei dem Beispiel in einer lagenweisen Anordnung angeordnet sein.

Die Empfangsspulen 3, 4 können mit jeweils zum Beispiel 3 Lagen ausgebildet sein.

Die erste Empfangsspule 3 und/oder die zweite Empfangsspule 4 können eine quadratische Form oder die Form einer Raute aufweisen; andere Formen zumindest einer der Empfangsspulen 3, 4 können jedoch auch vorgesehen sein.

Zwischen der ersten Empfangsspule 3 und der zweiten Empfangsspule 4 kann die Sendespule 5 angeordnet werden.

Die Sendespule 5 kann in einem Bereich von 3 bis 5 Lagen ausgebildet werden.

Die Spulenplatine 2 der Ausführungsform des induktiven Näherungsschalters 1 mit einer ersten und einer zweiten Empfangsspule 3, 4 kann bei dem Beispiel 14 Lagen aufweisen.

Die erste Empfangsspule 3 und die zweite Empfangsspule 4 weisen insbesondere entgegengesetzte Wicklungsrichtungen auf.

Bei dem Beispiel weist der induktive Näherungsschalter 1 ein Gehäuse 6 auf.

Das Gehäuse 6 hat bei dem in den Fig. 1A bis 1D gezeigten Beispiel einen quadratische Gehäusequerschnittsfläche. In der quadratischen Gehäusequerschnittsfläche können die erste und die zweite Empfangsspule 3, 4 in einer quadratischen Form, runden Form oder Rautenform vorgesehen sein.

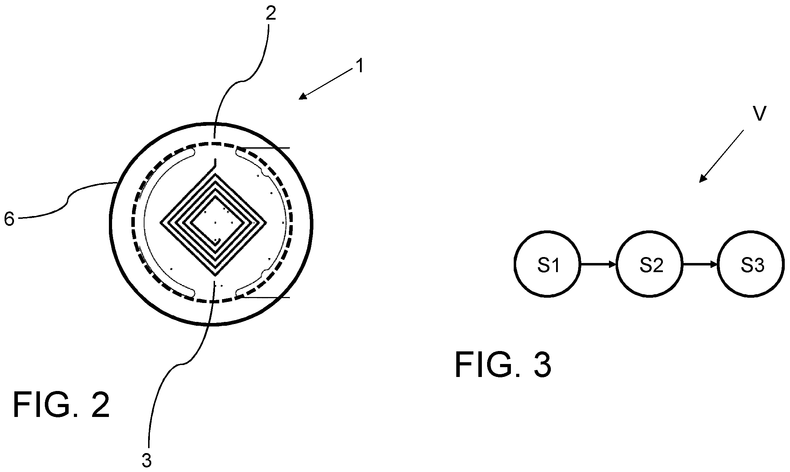

Bei der in Fig. 2 gezeigten alternativen Konfiguration des induktiven Näherungsschalters 1 weist das Gehäuse 6 einen runden Querschnitt auf. Auch die Spulenplatine 2 ist hier rund ausgebildet. Es ist beispielhaft lediglich eine Schicht einer ersten Empfangsspule 3 gezeigt, die mit einer quadratischen Form ausgebildet ist.

Die Ecken liegen dabei am Rand eines bedruckbaren Bereichs der Spulenplatine 2, während die Seiten des Quadrats einen größeren Abstand zum Gehäuse 6 aufweisen.

Bei diesem Beispiel sind eine erste 3 und zweite Empfangsspule 4 analog zu dem in Fig. 2 gezeigten Fall gebildet. Zwischen der ersten 3 und zweiten Empfangsspule 4 ist eine Sendespule 5 angeordnet.

Der Näherungsschalter 1 ist bei diesem Beispiel ansonsten analog zu dem oben erläuterten Beispiel gebildet.

Bei weiteren Beispielen kann das Gehäuse 6 länglich, oval oder rechteckig ausgebildet sein. In solchen alternativen Ausgestaltungen ist insbesondere eine Rautenform der ersten 3 und zweiten Empfangsspule 4 vorteilhaft.

Fig. 3 zeigt ein Ablaufdiagram eines offenbarungsgemäßen Verfahrens. Es wird von den oben erläuterten Ausführungsbeispielen des Spulensystems beziehungsweise des induktiven Näherungssensors ausgegangen.

In Fig. 3 bezeichnet das Bezugszeichen V eine Ausführungsform des Verfahrens.

Das Verfahren V zur Herstellung eines Spulensystems für einen induktiven Näherungsschalter 1 weist mehrere Verfahrensschritte auf.

In einem ersten Verfahrensschritt S1 wird zumindest eine erste Empfangsspule 3 auf einer Spulenplatine 2 des induktiven Näherungsschalters 1 in lagenweiser Anordnung ausgebildet, insbesondere durch Drucken der Leiterbahnen der Spulen.

In einem weiteren Verfahrensschritt S2 wird eine Sendespule 5 in lagenweiser Ausbildung auf der ersten Empfangsspule 3 ausgebildet. Die Sendespule 5 umfasst eine Spule, die insbesondere eine kreisrunde Form aufweist.

Die erste Empfangsspule 3 umfasst eine Spule, die in ihrer Form polygonal ausgebildet ist, insbesondere mit vier Seitenlängen und Innenwinkeln, die insbesondere symmetrisch und gleichmäßig zueinander verteilt sind.

Ferner ist ein weiterer Verfahrensschritt S3 vorgesehen, bei dem eine zweite Empfangsspule 4, die analog zur ersten Empfangsspule 3 ausgebildet ist, in lagenweiser Ausbildung auf der Sendespule 5 ausgebildet.

Die erste Empfangsspule 3, die zweite Empfangsspule 4 und die Sendespule 5 sind bei dem Beispiel übereinandergestapelt angeordnet.

Zudem können weitere Lagen für ein Abschirmgitter, Verbindungsleiterbahnen und eine Lage mit Anschlusspads für eine Elektronikplatine vorgesehen werden.

Mit der Anordnung der Spulen können sowohl nichtbündige, als auch als bündige Näherungsschalter mit den erforderlichen und marktüblichen Norm-Schaltabständen realisiert werden.

### Bezugszeichenliste

- 1: Induktiver Näherungsschalter
- 2: Spulenplatine
- 3: erste Empfangsspule
- 4: zweite Empfangsspule
- 5: Sendespule
- 6: Gehäuse
- 7: Gitter

- V: Verfahren
- S1, S2, S3: Verfahrensschritte

## Patentansprüche

1. Spulensystem für einen induktiven Näherungsschalter (1) zum bündigen oder nichtbündigen Einbau in ein Gehäuse (6), aufweisend:
- eine Spulenplatine (2), auf der zumindest eine erste Empfangsspule (3) und eine Sendespule (5) angeordnet sind;
- wobei die erste Empfangsspule (3) eine Spule umfasst, die in ihrer Form polygonal ausgebildet ist.

2. Spulensystem gemäß Anspruch 1, **dadurch gekennzeichnet, dass** die polygonale Form der ersten Empfangsspule (3) so ausgebildet ist, dass ihre Eckpunkte zumindest teilweise in einem Randbereich der Spulenplatine (2) angeordnet sind.

3. Spulensystem gemäß einem der vorhergehenden Ansprüche, **dadurch gekennzeichnet, dass**
die erste Empfangsspule (3) eine konvex polygonale Form aufweist, optional eine regelmäßig konvex polygonale Form, optional mit vier Seitenlängen und vier Innenwinkeln, die insbesondere symmetrisch und gleichmäßig zueinander verteilt sind;
wobei optional die erste Empfangsspule (3) eine Rautenform aufweist, insbesondere eine quadratische Form.

4. Spulensystem gemäß einem der vorhergehenden Ansprüche, **dadurch gekennzeichnet, dass**
die Sendespule (5) eine kreisrunde Form aufweist;
wobei optional die Sendespule (5) einen auf der Spulenplatine (2) maximal auszubildenden Durchmesser aufweist.

5. Spulensystem gemäß einem der vorhergehenden Ansprüche, **dadurch gekennzeichnet, dass**
ferner zumindest eine zweite Empfangsspule (4) vorgesehen ist,
wobei die erste Empfangsspule (3) und die zweite Empfangsspule (4) auf der Spulenplatine (2) lagenweise übereinander angeordnet sind, und
wobei die erste und die zweite Empfangsspule (3, 4) in der lagenweisen Anordnung jeweils mit 3 Lagen ausgebildet sind, und
wobei die Sendespule (5) zwischen der ersten und der zweiten Empfangsspule (3, 4) angeordnet ist, und
wobei die Sendespule (5) mit einer Mehrzahl von Lagen, insbesondere in einem Bereich von 1 bis 5 Lagen, ausgebildet ist.

6. Spulensystem gemäß einem der vorhergehenden Ansprüche, **dadurch gekennzeichnet, dass**
der Spulenstapel der Spulenplatine (2) 8 bis 16 Lagen, insbesondere 8 bis 14 Lagen, vorzugsweise 14 Lagen, aufweist.

7. Spulensystem gemäß Anspruch 5 oder 6, **dadurch gekennzeichnet, dass** die erste Empfangsspule (3) und die zweite Empfangsspule (4) entgegengesetzte Wicklungsrichtungen aufweisen.

8. Induktiver Näherungsschalter (1) mit einem Spulensystem gemäß einem der vorhergehenden Ansprüche und einem Gehäuse (6), wobei das Spulensystem bündig oder nichtbündig in dem Gehäuse (6) angeordnet ist und das Gehäuse (6) eine Gehäusequerschnittsfläche aufweist; wobei optional das Gehäuse zumindest teilweise aus Metall gebildet ist; wobei optional das Spulensystem im eingebauten Zustand in Umfangsrichtung zumindest teilweise von Metall umgeben ist.

9. Induktiver Näherungsschalter (1) gemäß dem unmittelbar vorhergehenden Anspruch, **dadurch gekennzeichnet, dass**
die Gehäusequerschnittsfläche quadratisch oder rund ausgebildet ist;
wobei optional bei einer quadratischen Gehäusequerschnittsfläche die erste Empfangsspule (4, 5), welche insbesondere quadratisch ausgebildet ist, gegenüber der quadratischen Gehäusequerschnittsfläche des Gehäuses (6) um 45° gedreht angeordnet ist; oder
wobei optional bei einer runden Gehäusequerschnittsfläche die erste Empfangsspule (4, 5) rautenförmig oder quadratisch ausgebildet ist.

10. Verfahren zur Herstellung eines Spulensystems für einen induktiven Näherungsschalter (1), mit den folgenden Verfahrensschritten:
- Ausbilden (S1) zumindest einer ersten Empfangsspule (3) auf einer Spulenplatine (2) in lagenweiser Anordnung; und
- Ausbilden (S2) einer Sendespule (5) in lagenweise Anordnung auf der ersten Empfangsspule (3),
wobei die Sendespule (5) insbesondere eine Spule mit einer kreisrunden Form aufweist; und
wobei die erste Empfangsspule (3) eine Spule mit einer polygonalen Form umfasst, insbesondere mit vier Seitenlängen und Innenwinkeln, die insbesondere symmetrisch und gleichmäßig zueinander verteilt sind.
